# EUROPEAN PATENT APPLICATION

(11) **EP 4 718 178 A1**
(43) Date of publication of application: **01.04.2026**
(21) Application number: 23942893.1
(22) Date of filing: 29.06.2023
(51) Int. Cl.: G05B 19/418

(54) **STATE SYNCHRONIZATION METHOD, APPARATUS AND SYSTEM FOR DIGITAL TWIN, AND DEVICE AND MEDIUM**

(71) Applicant: Siemens Aktiengesellschaft, 80333 München (DE)
(72) Inventor: YU, Yanbin, Shanghai 200082 (CN); ZHENG, Jie, Beijing 100102 (CN); FU, Ling, Shanghai 200082 (CN)
(74) Representative: Isarpatent
(86) International application number: PCT/CN2023/104156
(87) International publication number: WO 2025/000384

(57) **Abstract**

Disclosed in embodiments of the present invention are a state synchronization method, apparatus, and system for a digital twin, a device, and a medium. The method includes: obtaining a first state sequence and a second state sequence, where the first state sequence represents a state of a virtual control system for a digital twin, and the second state sequence represents a state of a control system for a mapped object of the digital twin; when the first state sequence is inconsistent with the second state sequence, determining a desired state of the digital twin based on the second state sequence; and updating a state of the digital twin to the desired state. The efficiency of state synchronization is improved, implementation costs and workload are reduced, the normal operation of a mapped object is ensured, and the working efficiency of the mapped object is improved.

## Description

### TECHNICAL FIELD

The present invention relates to the field of digital twin technologies, and in particular, to a state synchronization method, apparatus, and system for a digital twin, device, and medium.

### BACKGROUND

A digital twin makes full use of data such as physical models, sensor updates, and operational history, integrating multidisciplinary, multiphysics, multi-scale, and multi-probability simulation processes to complete mapping in a virtual space, thereby reflecting the full lifecycle process of corresponding physical equipment.

How to maintain state synchronization between the digital twin and a mapped object (e.g., a physical production system) is a critical requirement.

### SUMMARY

Embodiments of the present invention provide a state synchronization method, apparatus, and system for a digital twin, a device, and a medium.

A state synchronization method for a digital twin includes:
obtaining a first state sequence and a second state sequence, where the first state sequence represents a state of a virtual control system for a digital twin, and the second state sequence represents a state of a control system for a mapped object of the digital twin;
when the first state sequence is inconsistent with the second state sequence, determining a desired state of the digital twin based on the second state sequence; and
updating a state of the digital twin to the desired state.

It can be learned that, compared with existing technologies in which a digital twin and a mapped object are simultaneously set to achieve state synchronization, in embodiments of the present invention, when the first state sequence is inconsistent with the second state sequence, the desired state of the digital twin is determined based on the second state sequence that represents the state of the control system for the mapped object of the digital twin, thereby improving the efficiency of state synchronization, reducing implementation costs and workload, ensuring the normal operation of the mapped object, and improving the working efficiency of the mapped object.

In an embodiment, the method includes:
when the first state sequence is inconsistent with the second state sequence, updating a current state of the virtual control system for the digital twin to a latest state in the second state sequence.

Therefore, when the first state sequence is inconsistent with the second state sequence, the current state of the virtual control system may be directly updated by using the latest state in the second state sequence, thereby updating the state of the virtual control system in time.

In an embodiment, the method includes:
running a simulation process of controlling the digital twin via the virtual control system;
synchronously acquiring a plurality of states of the virtual control system and a plurality of states of the digital twin in the simulation process, where the plurality of states of the virtual control system form a first acquired state sequence, and the plurality of states of the digital twin form a second acquired state sequence; and
generating a knowledge base including an association relationship between the first acquired state sequence and the second acquired state sequence.

It can be learned that, in the simulation process of controlling the digital twin via the virtual control system, respective state sequences of the virtual control system and the digital twin are synchronously acquired, and the knowledge base including the association relationship between the two state sequences is established, thereby facilitating subsequent determination of the desired state based on the knowledge base.

In an embodiment, the determining a desired state of the digital twin based on the second state sequence includes:
determining, from the first acquired state sequence in the knowledge base using the second state sequence as a comparison target, a hit region meeting the comparison target;
determining, from the second acquired state sequence, a latest state that is of the digital twin and that corresponds to a latest state of the virtual control system in the hit region; and
determining the latest state of the digital twin as the desired state.

Therefore, the desired state of the digital twin can be conveniently determined by using the second state sequence as the comparison target for comparison with the knowledge base.

In an embodiment, the second state sequence has a predetermined time length; and
the determining, from the first acquired state sequence in the knowledge base using the second state sequence as a comparison target, a hit region meeting the comparison target includes:
sliding a time window having the time length in the first acquired state sequence in the knowledge base;
determining a region that is within the time window and that has a maximum similarity with the second state sequence; and
determining the region having the maximum similarity as the hit region.

It can be learned that the hit region can be quickly determined through window sliding.

In an embodiment, the method includes:
obtaining a current state of the virtual control system;
when the current state is the same as a latest state in the first state sequence, updating a timestamp of the latest state to a timestamp of the current state; and
when the current state is different from the latest state in the first state sequence, adding the current state to the first state sequence.

Therefore, through a process of comparing the current state of the virtual control system with the latest state in the first state sequence, extension or timestamp updating may be performed on the first state sequence, so that the first state sequence can be updated in time.

In an embodiment, the method includes:
obtaining a current state of the control system;
when the current state is the same as a latest state in the second state sequence, updating a timestamp of the latest state to a timestamp of the current state; and
when the current state is different from the latest state in the second state sequence, adding the current state to the second state sequence.

Therefore, through a process of comparing the current state of the control system with the latest state in the second state sequence, extension or timestamp updating may be performed on the second state sequence, so that the second state sequence can be updated in time.

A state synchronization apparatus for a digital twin includes:
an obtaining module, configured to obtain a first state sequence and a second state sequence, where the first state sequence represents a state of a virtual control system for a digital twin, and the second state sequence represents a state of a control system for a mapped object of the digital twin;
a determination module, configured to: when the first state sequence is inconsistent with the second state sequence, determine a desired state of the digital twin based on the second state sequence; and
an update module, configured to update a state of the digital twin to the desired state.

It can be learned that, compared with existing technologies in which a digital twin and a mapped object are simultaneously set to achieve state synchronization, in embodiments of the present invention, when the first state sequence is inconsistent with the second state sequence, the desired state of the digital twin is determined based on the second state sequence that represents the state of the control system for the mapped object of the digital twin, thereby improving the efficiency of state synchronization, reducing implementation costs and workload, ensuring the normal operation of the mapped object, and improving the working efficiency of the mapped object.

In an embodiment, the determination module is configured to: when the first state sequence is inconsistent with the second state sequence, update a current state of the virtual control system for the digital twin to a latest state in the second state sequence.

Therefore, when the first state sequence is inconsistent with the second state sequence, the current state of the virtual control system may be directly updated by using the latest state in the second state sequence, thereby updating the state of the virtual control system in time.

In an embodiment, the determination module is configured to: run a simulation process of controlling the digital twin via the virtual control system; synchronously acquire a plurality of states of the virtual control system and a plurality of states of the digital twin in the simulation process, where the plurality of states of the virtual control system form a first acquired state sequence, and the plurality of states of the digital twin form a second acquired state sequence; and generate a knowledge base including an association relationship between the first acquired state sequence and the second acquired state sequence.

It can be learned that, in the simulation process of controlling the digital twin via the virtual control system, respective state sequences of the virtual control system and the digital twin are synchronously acquired, and the knowledge base including the association relationship between the two state sequences is established, thereby facilitating subsequent determination of the desired state based on the knowledge base.

In an embodiment, the determination module is configured to: determine, from the first acquired state sequence in the knowledge base using the second state sequence as a comparison target, a hit region meeting the comparison target; determine, from the second acquired state sequence, a latest state that is of the digital twin and that corresponds to a latest state of the virtual control system in the hit region; and determine the latest state of the digital twin as the desired state.

Therefore, the desired state of the digital twin can be conveniently determined by using the second state sequence as the comparison target for comparison with the knowledge base.

In an embodiment, the second state sequence has a predetermined time length; and
the determination module is configured to: slide a time window having the time length in the first acquired state sequence in the knowledge base; determine a region that is within the time window and that has a maximum similarity with the second state sequence; and determine the region having the maximum similarity as the hit region.

It can be learned that the hit region can be quickly determined through window sliding.

A state synchronization system for a digital twin includes:
a virtual control system, configured to control a digital twin;
a control system, configured to control a mapped object of the digital twin; and
a state synchronization apparatus, configured to: obtain a first state sequence and a second state sequence, where the first state sequence represents a state of the virtual control system for the digital twin, and the second state sequence represents a state of the control system for the mapped object of the digital twin; when the first state sequence is inconsistent with the second state sequence, determine a desired state of the digital twin based on the second state sequence; and update a state of the digital twin to the desired state.

It can be learned that, compared with existing technologies in which a digital twin and a mapped object are simultaneously set to achieve state synchronization, in embodiments of the present invention, when the first state sequence is inconsistent with the second state sequence, the desired state of the digital twin is determined based on the second state sequence that represents the state of the control system for the mapped object of the digital twin, thereby improving the efficiency of state synchronization, reducing implementation costs and workload, ensuring the normal operation of the mapped object, and improving the working efficiency of the mapped object.

In an embodiment, the state synchronization apparatus is configured to: run a simulation process of controlling the digital twin via the virtual control system; synchronously acquire a plurality of states of the virtual control system and a plurality of states of the digital twin in the simulation process, where the plurality of states of the virtual control system form a first acquired state sequence, and the plurality of states of the digital twin form a second acquired state sequence; and generate a knowledge base including an association relationship between the first acquired state sequence and the second acquired state sequence.

It can be learned that, in the simulation process of controlling the digital twin via the virtual control system, respective state sequences of the virtual control system and the digital twin are synchronously acquired, and the knowledge base including the association relationship between the two state sequences is established, thereby facilitating subsequent determination of the desired state based on the knowledge base.

In an embodiment, the state synchronization apparatus is configured to: determine, from a first acquired state sequence in the knowledge base using the second state sequence as a comparison target, a hit region meeting the comparison target; determine, from a second acquired state sequence, a latest state that is of the digital twin and that corresponds to a latest state of the virtual control system in the hit region; and determine the latest state of the digital twin as the desired state.

Therefore, the desired state of the digital twin can be conveniently determined by using the second state sequence as the comparison target for comparison with the knowledge base.

In an embodiment, the second state sequence has a predetermined time length; and
the state synchronization apparatus is configured to: slide a time window having the time length in the first acquired state sequence in the knowledge base; determine a region that is within the time window and that has a maximum similarity with the second state sequence; and determine the region having the maximum similarity as the hit region.

It can be learned that the hit region can be quickly determined through window sliding.

An electronic device includes:
a processor; and
a memory, configured to store executable instructions of the processor, where
the processor is configured to read the executable instructions from the memory and execute the executable instructions to implement the foregoing state synchronization method for a digital twin.

A computer-readable storage medium has computer instructions stored therein, where the computer instructions, when executed by a processor, implement the foregoing state synchronization method for a digital twin.

A computer program product includes a computer program, where the computer program, when executed by a processor, implements the foregoing state synchronization method for a digital twin.

### BRIEF DESCRIPTION OF THE DRAWINGS

To enable a person of ordinary skill in the art to understand the foregoing and other features and advantages of the present invention more clearly, exemplary embodiments according to the present invention are described in detail below with reference to the accompanying drawings. In the accompanying drawings:
FIG. 1 is a flowchart of a state synchronization method for a digital twin according to an embodiment of the present invention;
FIG. 2 is an exemplary schematic diagram of a first state sequence and a second state sequence according to an embodiment of the present invention;
FIG. 3 is an exemplary flowchart of generating a state sequence according to an embodiment of the present invention;
FIG. 4 is an exemplary schematic diagram of generating a knowledge base according to an embodiment of the present invention;
FIG. 5 is an exemplary schematic diagram of determining a desired state of a digital twin according to an embodiment of the present invention;
FIG. 6 is a structural diagram of a state synchronization system for a digital twin according to an embodiment of the present invention;
FIG. 7 is a structural diagram of a state synchronization apparatus for a digital twin according to an embodiment of the present invention; and
FIG. 8 is a structural diagram of an electronic device according to an embodiment of the present invention.

**Reference numerals:**

| Numeral | Meaning |
|---|---|
| 101 to 103 | Step |
| 10 | Second state sequence |
| 20 | First state sequence |
| 11 | First comparison region |
| 21 | Second comparison region |
| 301 to 304 | Step |
| 30 | Entry of the knowledge base |
| 31 | State of the virtual control system |
| 32 | State of the digital twin |
| 33 | Virtual control system |
| 34 | Digital twin |
| 50 | Knowledge base |
| 40 | Comparison region |
| 41 | Hit region |
| 42 | desired state of the digital twin |
| 601 | Digital twin |
| 602 | Virtual control system |
| 603 | State synchronization apparatus |
| 604 | Control system |
| 605 | Mapped object of the digital twin |
| 700 | State synchronization apparatus |
| 701 | Obtaining module |
| 702 | Determination module |
| 703 | Update module |
| 800 | Electronic device |
| 801 | Processor |
| 802 | Memory |

### DETAILED DESCRIPTION

To make the objectives, technical solutions, and advantages of the present invention clearer, the present invention is further described in detail below with reference to embodiments.

For the sake of conciseness and clarity in description, the solutions of the present invention are described below by describing several representative embodiments. A large number of details in the embodiments are provided only to aid in understanding the solutions of the present invention. However, it is evident that the technical solutions of the present invention may be implemented without being limited to these details. To avoid unnecessarily obscuring the solutions of the present invention, some embodiments are not described in detail but are presented only in outline form. In the following description, "including" means "including, but not limited to", and "based on ..." means "at least based on ..., but not limited to only based on ...". Due to the linguistic conventions of Chinese, when a quantity is not specifically stated for a component in the following description, it implies that one or more components may be provided, or it may be understood that at least one component is provided.

During product research and development, a digital twin may virtually construct a digital model of a product, and simulation testing and verification are performed on the digital model of the product. During product production and manufacturing, the digital twin may simulate device operation and changes brought by parameter adjustment. How to maintain state synchronization between the digital twin and a mapped object (e.g., a physical production system) is a critical requirement. For example, to build an industrial metaverse application, a physical production system needs to be projected to a virtual space for monitoring, analysis, and prediction. In this case, a key problem is to maintain state synchronization between a digital twin of the physical production system and the physical production system.

The applicant has found that achieving such state synchronization is difficult in practical scenarios. The main reasons include at least the following: (1) Insufficient sensing points: Adding additional sensors to detect the state of the physical production system is uneconomical. (2) Difficulty in creating a perfect digital twin of the physical production system that accounts for all possibilities: Under normal circumstances, only normal conditions and some abnormal conditions can be taken into consideration during modeling of the digital twin. If more potential scenarios that the physical production may face are included, the workload will increase significantly. (3) Limited bandwidth and communication latency: It is difficult to transmit a large volume of data between the digital twin and the physical production system.

Embodiments of the present invention provide a general technical solution with low-cost implementation, so that state synchronization between a digital twin and a mapped object can be achieved, thereby reducing implementation costs and workload, ensuring the normal operation of the mapped object, and improving the working efficiency of the mapped object.

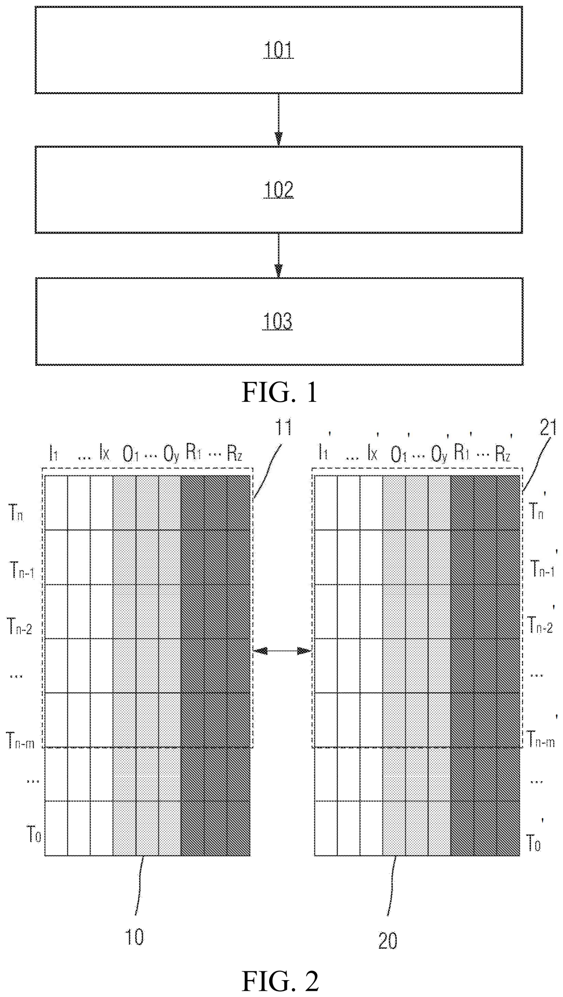

FIG. 1 is a flowchart of a state synchronization method for a digital twin according to an embodiment of the present invention. As shown in FIG. 1, the method includes the following steps.

Step 101: Obtain a first state sequence and a second state sequence, where the first state sequence represents a state of a virtual control system for a digital twin, and the second state sequence represents a state of a control system for a mapped object of the digital twin.

The digital twin is a simulation model representing the mapped object (for example, a physical production line) of the digital twin. The mapped object of the digital twin may be implemented as a real production system in the physical world. For example, the mapped object may be a production line. The control system (usually a real control system in the physical world) for the mapped object is configured to drive the mapped object. For example, the control system for the mapped object may be implemented as a programmable logic controller (PLC) having control logic (for example, a program). The virtual control system drives the digital twin. The digital twin may receive a command from the virtual control system for the digital twin and trigger actions. For example, the digital twin may be a production line simulation model in Tecnomatix factory simulation, and the virtual control system may be implemented as a PLC simulator. Control logic of the PLC simulator is the same as that of the control system for the mapped object of the digital twin. When conditions in the digital twin change, the digital twin generates sensing data, and the sensing data is fed to the virtual control system.

The following describes a specific manner of obtaining the first state sequence and the second state sequence.

Manner (1): Obtain the first state sequence and the second state sequence based on a predetermined acquisition time sequence.

In Manner (1), the first state sequence may be implemented as a state sequence that is of the virtual control system and that is based on the acquisition time sequence. Correspondingly, the second state sequence is a state sequence that is of the virtual control system and that is based on the same acquisition time sequence. The first state sequence and the second state sequence are synchronous in time. That is, each state in the first state sequence is synchronized with a corresponding state in the second state sequence in terms of acquisition time. Preferably, the first state sequence includes a latest state of the virtual control system (located at a latest acquisition time point of the first state sequence), and the second state sequence includes a latest state of the control system for the mapped object (located at a latest acquisition time point of the second state sequence). The same acquisition time sequence is used in this manner of obtaining the first state sequence and the second state sequence. Therefore, the first state sequence and the second state sequence can be conveniently obtained. However, because a state may remain unchanged within a long time, the first state sequence and the second state sequence may be long.

Manner (2): A state is added to the first state sequence only when a state of the virtual control system changes, and a state is added to the second state sequence only when a state of the control system changes.

In Manner (2), a state record is added to the first state sequence and the second state sequence only when a state changes, thereby keeping the first state sequence and the second state sequence from becoming excessively long.

In an embodiment, the method includes: obtaining a current state of the virtual control system; when the current state is the same as a latest state in the first state sequence, updating a timestamp of the latest state to a timestamp of the current state; and when the current state is different from the latest state in the first state sequence, adding the current state to the first state sequence. In an embodiment, the method includes: obtaining a current state of the control system; when the current state is the same as a latest state in the second state sequence, updating a timestamp of the latest state to a timestamp of the current state; and when the current state is different from the latest state in the second state sequence, adding the current state to the second state sequence.

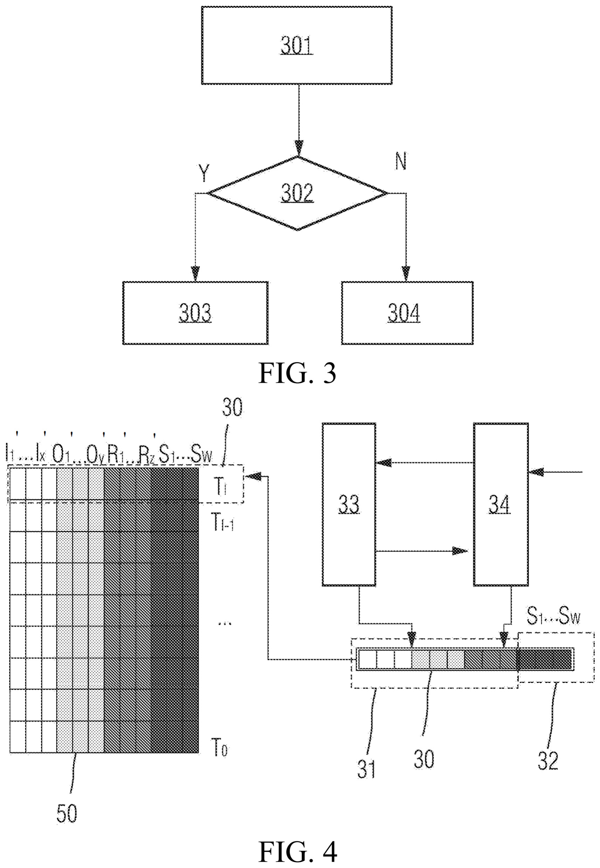

FIG. 3 is an exemplary flowchart of generating a state sequence according to an embodiment of the present invention. The method is applicable to generating the first state sequence and the second state sequence.

As shown in FIG. 3, the method includes the following steps.

Step 301: Obtain a current state.

Step 302: Determine whether the current state is the same as a latest state in a state sequence, and if the current state is the same as the latest state in the state sequence, perform Step 303 (corresponding to the "Y" branch), or if the current state is different from the latest state in the state sequence, perform Step 304 (corresponding to the "N" branch), and end this process.

Step 303: Update a timestamp of the latest state to a timestamp of the current state, and end the process.

Step 304: Add the current state to the state sequence, and end the process.

For example, it is assumed that the latest state in the first state sequence (that is, a latest entry in the first state sequence) includes an input value A, an output value B, and a virtual register value C, with a timestamp being D. The currently acquired current state of the virtual control system includes the input value A, the output value B, and the virtual register value C, with a timestamp being E (a current time). Because the current state is the same as the latest state in the first state sequence, it is only necessary to change a timestamp of a latest entry in the first state sequence from D to E.

For another example, it is assumed that the latest state in the first state sequence (that is, a latest entry in the first state sequence) includes an input value A, an output value B, and a virtual register value F, with a timestamp being D. The currently acquired current state of the virtual control system includes the input value A, the output value B, and a virtual register value C, with a timestamp being E (a current time). Because the current state is different from the latest state in the first state sequence, a new entry needs to be added to the first state sequence. Content of the newly added entry is: the input value A, the output value B, and the virtual register value C, with the timestamp being E. The newly added entry is updated into the latest state in the first state sequence.

Therefore, through a process of comparing the current state of the virtual control system with the latest state in the first state sequence, extension or timestamp updating may be performed on the first state sequence, so that the first state sequence can be updated in time.

For example, it is assumed that the latest state in the second state sequence (that is, a latest entry in the second state sequence) includes an input value A, an output value B, and a register value C, with a timestamp being D. The currently acquired current state of the control system includes the input value A, the output value B, and the register value C, with a timestamp being E (a current time). Because the current state is the same as the latest state in the second state sequence, it is only necessary to change a timestamp of a latest entry in the second state sequence from D to E.

For another example, it is assumed that the latest state in the second state sequence (that is, a latest entry in the second state sequence) includes an input value A, an output value B, and a register value F, with a timestamp being D. The currently acquired current state of the control system includes the input value A, the output value B, and a register value C, with a timestamp being E (a current time). Because the current state is different from the latest state in the second state sequence, a new entry needs to be added to the second state sequence. Content of the newly added entry is: the input value A, the output value B, and the register value C, with the timestamp being E. The newly added entry is updated into the latest state in the second state sequence.

Therefore, through a process of comparing the current state of the control system with the latest state in the second state sequence, extension or timestamp updating may be performed on the second state sequence, so that the second state sequence can be updated in time.

Preferably, the state included in the first state sequence may be specifically implemented as an input value of the virtual control system, an output value of the virtual control system, and/or a state of the virtual register in the virtual control system. The state included in the second state sequence may be specifically implemented as an input value of the control system, an output value of the control system, and/or a state of corresponding register in the control system.

When the first state sequence and the second state sequence are generated based on Manner (1): sequentially reading values of an input/output port in the virtual control system and accessing the virtual register in the virtual control system based on the predetermined acquisition time sequence, a state of the virtual control system at each acquisition time point may be correspondingly obtained, thereby forming the first state sequence. Similarly, values of an input/output port in the control system are sequentially read and the register in the control system is accessed based on an acquisition time sequence equivalent to that of the first state sequence, and a state of the control system at each acquisition time point may be correspondingly obtained, thereby forming the second state sequence.

When the first state sequence and the second state sequence are generated based on Manner (2), a state is added to the first state sequence only when a value of an input/output port in the virtual control system or a virtual register in the virtual control system changes, or otherwise, only a timestamp of the latest same state is updated; and a state is added to the second state sequence only when a value of an input/output port in the control system or a register in the control system changes, or otherwise, only a timestamp of the latest same state is updated.

FIG. 2 is an exemplary schematic diagram of a first state sequence and a second state sequence according to an embodiment of the present invention.

In FIG. 2, a second state sequence 10 includes states of the control system that are sequentially acquired based on an acquisition sequence (T₀, T₁, ..., and Tₙ). Each state includes input values (I₁, I₂, ..., and Iₓ) of the control system, output values (O₁, O₂, ..., and O_{y}) of the control system, and values (R₁, R₂, ..., R_{z}) of the register in the control system. Tₙ is the latest acquisition point.

A first state sequence 20 includes states of the virtual control system that are sequentially acquired based on an acquisition sequence (T₀', T₁', ..., and Tₙ'). Each state includes input values (I₁', I₂', ..., and Iₓ') of the virtual control system, output values (O₁', O₂', ..., and O_{y}') of the virtual control system, and values (R₁', R₂', ..., R_{z}') of the virtual register in the virtual control system. Tₙ is the latest acquisition point.

When the first state sequence 20 and the second state sequence 10 are generated based on Manner (1), the acquisition sequences (T₀, T₁, ..., and Tₙ) and (T₀', T₁', ..., and Tₙ') are equivalent, both being sequences of acquisition time points. For example, when a sampling period is 1 second, T₀ (T₀') is the 1^{st} second, T₁ (T₁') is the 2^{nd} second, ..., and Tₙ (Tₙ') is an (n+1)^{th} second.

When the first state sequence 20 and the second state sequence 10 are generated based on Manner (2), the acquisition sequences (T₀, T₁, ..., and Tₙ) and (T₀', T₁', ..., and Tₙ') are both sequences of state changes in the respective sequences. For example, T₀ is a moment at which a state is acquired for the first time of the second state sequence 10, T₁ is a moment at which it is acquired that the state of the control system changes for the first time, ..., and Tₙ is a moment at which it is acquired that the state of the control system changes for the n^{th} time. For example, T₀' is a moment at which a state is acquired for the first time of the first state sequence 20, T₁' is a moment at which it is acquired that the state of the virtual control system changes for the first time, ..., and Tₙ' is a moment at which it is acquired that the state of the virtual control system changes for the n^{th} time. In terms of specific time and the quantity of sampling points, (T₀, T₁, ..., and Tₙ) and (T₀', T₁', ..., and Tₙ') may not completely correspond to each other.

Step 102: When the first state sequence is inconsistent with the second state sequence, determining a desired state of the digital twin based on the second state sequence.

The same obtaining manner is used for the first state sequence and the second state sequence used as comparison objects. For example, the first state sequence and the second state sequence are both obtained in Manner (1) or are both obtained in Manner (2).

The complete first state sequence may be compared with the complete second state sequence. When the complete first state sequence is inconsistent with the complete second state sequence, it is determined that the first state sequence is inconsistent with the second state sequence. Optionally, a region that includes a latest record and that has a predetermined time length may be extracted from the first state sequence and compared with a region that is extracted from the second state sequence, that includes a latest record, and that has the same time length. When the two regions are inconsistent, it is determined that the first state sequence is inconsistent with the second state sequence.

For example, referring to FIG. 2, a first comparison region 11 including a latest state record is extracted from the first state sequence 10, and is compared with a second comparison region 21 including a latest state record extracted from the second state sequence 20. The first comparison region 11 and the second comparison region 21 have the same time length.

In this case, when the first state sequence is inconsistent with the second state sequence, it is determined that the state of the digital twin is not synchronous with the state of the mapped object. Therefore, the state of the digital twin needs to be updated. The desired state of the digital twin may be determined based on the second state sequence. For example, the desired state of the digital twin may specifically include: a desired rotational speed of a rotating shaft, a desired rotation angle of a robotic arm, and the like.

In an embodiment, the method includes: running a simulation process of controlling the digital twin via the virtual control system; synchronously acquiring a plurality of states of the virtual control system and a plurality of states of the digital twin in the simulation process based on a time sequence of the simulation process, where the plurality of states of the virtual control system form a first acquired state sequence, and the plurality of states of the digital twin form a second acquired state sequence; and generating a knowledge base including an association relationship between the first acquired state sequence and the second acquired state sequence.

It can be learned that, in the simulation process (the control system and the mapped object may not participate in the simulation process) of controlling the digital twin via the virtual control system, respective state sequences of the virtual control system and the digital twin are synchronously acquired, and the knowledge base including the association relationship between the two state sequences is established, thereby facilitating subsequent determination of the desired state based on the knowledge base.

FIG. 4 is an exemplary schematic diagram of generating a knowledge base according to an embodiment of the present invention. First, a simulation process of controlling a digital twin 34 via a virtual control system 33 is run. Next, a plurality of states (each state includes input values (I₁', I₂', ..., and Iₓ') of the virtual control system 33, output values (O₁', O₂', ..., and O_{y}') of the virtual control system 33, and values (R₁', R₂', ..., R_{z}') of the virtual register in the virtual control system 33) of the virtual control system 33 and a plurality of states of the digital twin 34 that respectively correspond to the states of the virtual control system 33 (each state of the digital twin 34 includes specific values of S1, ..., and Sw, where S1, ..., and Sw are specific parameters of the digital twin 34, for example, S1 is a rotation angle, and S2 is a displacement) in the simulation process are synchronously acquired. The plurality of states of the virtual control system 33 form a first acquired state sequence, and the plurality of states of the digital twin form a second acquired state sequence 34.

The first acquired state sequence and the second acquired state sequence may be obtained based on the predetermined acquisition time sequence in Manner (1). In Manner (1), the plurality of states of the virtual control system 33 and the plurality of corresponding states of the digital twin 34 in the simulation process are synchronously acquired based on the acquisition time sequence. The first acquired state sequence and the second acquired state sequence are synchronous in time. For example, when the sampling period is 1 second, a state A1 at the 1^{st} second, a state A2 at the 2^{nd} second, ..., and a state An at an n^{th} second of the virtual control system 33 as well as a state B1 at the 1^{st} second, a state B2 at the 2^{nd} second, ..., and a state Bn at the n^{th} second of the digital twin 34 are acquired. (A1, A2, ..., and An) form the first acquired state sequence, and (B1, B2, ..., and Bn) form the second acquired state sequence.

The first acquired state sequence and the second acquired state sequence may be obtained based on Manner (2). A state is added to the first acquired state sequence only when the state of the virtual control system 33 changes, and correspondingly, a state of the digital twin 34 is synchronously added to the second acquired state sequence. For example, it is assumed that the latest state in the first acquired state sequence (that is, a latest entry in the first acquired state sequence) includes an input value A, an output value B, and a virtual register value F, with a timestamp being D. In the simulation process, the currently acquired current state of the virtual control system includes the input value A, the output value B, and a virtual register value C, with a timestamp being E (a current time). Because the current state is different from the latest state in the first acquired state sequence, a new entry needs to be added to the first acquired state sequence. Content of the newly added entry is: the input value A, the output value B, and the virtual register value C, with the timestamp being E. The newly added entry is updated into the latest state in the first acquired state sequence. Correspondingly, a new entry is synchronously added to the second acquired state sequence. Content of the newly added entry is: a state of the digital twin 33 acquired at the timestamp being E.

A knowledge base 50 may be formed by associating the first acquired state sequence with the second acquired state sequence. In FIG. 4, each entry 30 in the knowledge base 50 includes: a state 31 (each state includes input values (I₁', I₂', ..., and Iₓ') of the virtual control system 33, output values (O₁', O₂', ..., and O_{y}') of the virtual control system 33, and values (R₁', R₂', ..., R_{z}') of the virtual register in the virtual control system 33) that corresponds to respective acquisition sequence numbers and that is of the virtual control system 33 and a state 32 (each state includes specific parameters S1, ..., and Sw of the digital twin) that is correspondingly synchronously acquired and that is of the digital twin. The acquisition sequence numbers in the knowledge base 50 are (T₀, T₁, ..., and T₁), where T₁ is a latest entry.

In an embodiment, the determining a desired state of the digital twin based on the second state sequence includes: determining, from the first acquired state sequence in the knowledge base using the second state sequence as a comparison target, a hit region meeting the comparison target; determining, from the second acquired state sequence, a latest state that is of the digital twin and that corresponds to a latest state of the virtual control system in the hit region; and determining the latest state of the digital twin as the desired state. Therefore, the desired state of the digital twin can be conveniently determined by using the second state sequence as the comparison target for comparison with the knowledge base.

In an embodiment, the second state sequence has a predetermined time length; and the determining, from the first acquired state sequence in the knowledge base using the second state sequence as a comparison target, a hit region meeting the comparison target includes: sliding a time window having the time length in the first acquired state sequence in the knowledge base; determining a region that is within the time window and that has a maximum similarity with the second state sequence; and determining the region having the maximum similarity as the hit region. It can be learned that the hit region can be quickly determined through window sliding. Specifically, the region having the maximum similarity may be determined in a pattern recognition manner, an eigenvector manner, a fuzzy matching manner, a probability manner, or the like.

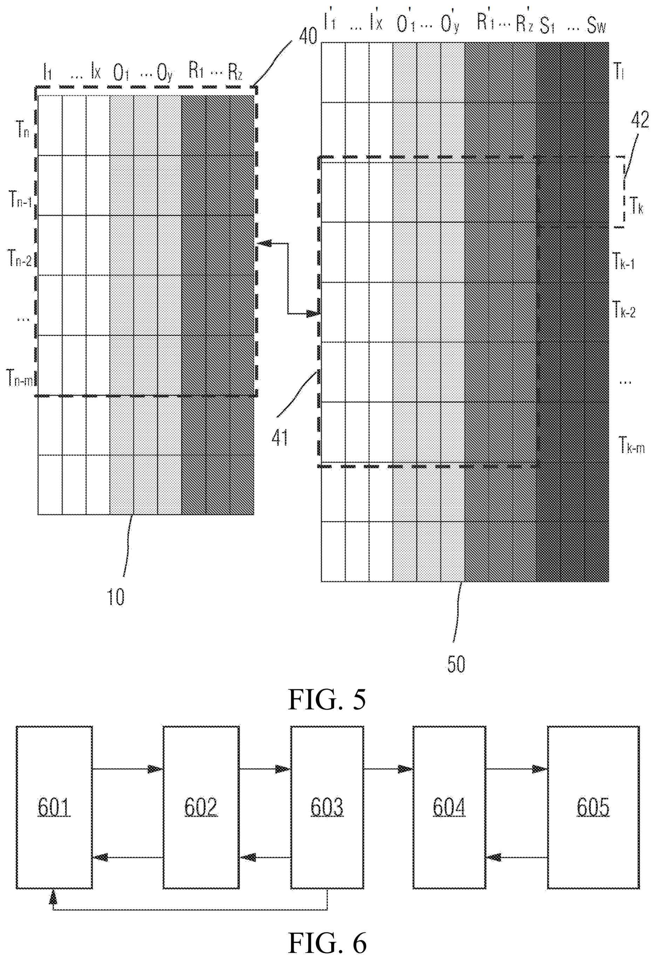

FIG. 5 is an exemplary schematic diagram of determining a desired state of a digital twin according to an embodiment of the present invention.

In FIG. 5, the second state sequence 10 and the knowledge base 50 are obtained in the same manner. For example, the second state sequence 10 and the knowledge base 50 are both obtained in the foregoing Manner (1) or the foregoing Manner (2). A comparison region 40 having a predetermined time length is selected from the second state sequence 10. A hit region 41 having the maximum similarity is determined through sliding in the first acquired state sequence of the knowledge base 50 with a time length (Tₙ₋ₘ to Tₙ) of the comparison region 40 as a sliding window. Next, a latest state that is of the digital twin and that corresponds to a latest state of the virtual control system in the hit region 41 is read from the second acquired state sequence of the knowledge base 50; and the latest state of the digital twin is determined as the desired state.

For example, in FIG. 4, an acquisition sequence T corresponding to the hit region 41 is Tₖ₋ₘ to Tₖ. A latest acquisition point in the hit region 41 is Tₖ. Therefore, a state 42 that is of the digital twin, that is in the second acquired state sequence, and that corresponds to Tₖ is determined as the desired state.

Step 103: Update a state of the digital twin to the desired state.

FIG. 6 is a structural diagram of a state synchronization system for a digital twin according to an embodiment of the present invention. The system includes: a virtual control system 602, configured to control a digital twin 601; and a control system 604, configured to control a mapped object 605 of the digital twin 601.

First, a state synchronization apparatus 603 is configured to: run a simulation process (the control system 604 and the mapped object 605 may not participate in the simulation process) of controlling the digital twin 601 via the virtual control system 602; correspondingly synchronously acquire a plurality of states of the virtual control system 602 and a plurality of corresponding states of the digital twin 601 in the simulation process, where the plurality of states of the virtual control system 602 form a first acquired state sequence, and the plurality of states of the digital twin 601 form a second acquired state sequence; and generate a knowledge base including an association relationship between the first acquired state sequence and the second acquired state sequence.

After the knowledge base is generated, the digital twin 601, the virtual control system 602, the control system 604, and the mapped object 605 start to run. During running, the state synchronization apparatus 603, configured to: obtain a first state sequence and a second state sequence, where the first state sequence represents a state of the virtual control system 602 for the digital twin 601, and the second state sequence represents a state of the control system 604 for the mapped object 605 of the digital twin 601; when the first state sequence is inconsistent with the second state sequence, determine a desired state of the digital twin 601 based on the second state sequence; and update a state of the digital twin 601 to the desired state.

In an embodiment, the state synchronization apparatus 603 is configured to: determine, from a first acquired state sequence in the knowledge base using the second state sequence as a comparison target, a hit region meeting the comparison target; determine, from a second acquired state sequence, a latest state that is of the digital twin 601 and that corresponds to a latest state of the virtual control system 602 in the hit region; and determine the latest state of the digital twin 601 as the desired state.

In an embodiment, the second state sequence has a predetermined time length; and the state synchronization apparatus 603 is configured to: slide a time window having the time length in the first acquired state sequence in the knowledge base; determine a region that is within the time window and that has a maximum similarity with the second state sequence; and determine the region having the maximum similarity as the hit region.

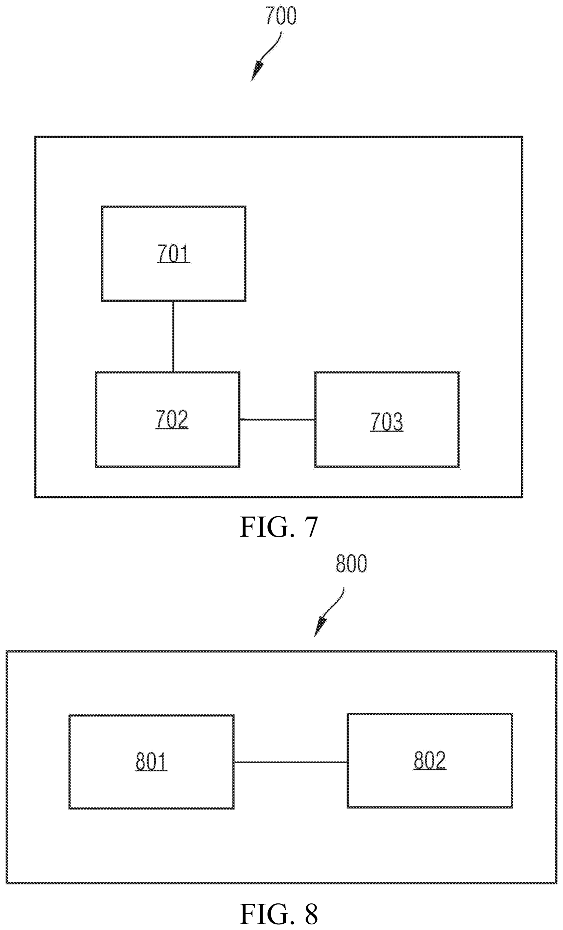

FIG. 7 is a structural diagram of a state synchronization apparatus for a digital twin according to an embodiment of the present invention; and As shown in FIG. 7, a state synchronization apparatus 700 for a digital twin includes:
an obtaining module 701, configured to obtain a first state sequence and a second state sequence, where the first state sequence represents a state of a virtual control system for a digital twin, and the second state sequence represents a state of a control system for a mapped object of the digital twin; a determination module 702, configured to: when the first state sequence is inconsistent with the second state sequence, determine an desired state of the digital twin based on the second state sequence; and an update module 703, configured to update a state of the digital twin to the desired state.

In an embodiment, the determination module 702 is configured to: when the first state sequence is inconsistent with the second state sequence, update a current state of the virtual control system for the digital twin to a latest state in the second state sequence.

In an embodiment, the determination module 702 is configured to: run a simulation process of controlling the digital twin via the virtual control system; synchronously acquire a plurality of states of the virtual control system and a plurality of states of the digital twin in the simulation process, where the plurality of states of the virtual control system form a first acquired state sequence, and the plurality of states of the digital twin form a second acquired state sequence; and generate a knowledge base including an association relationship between the first acquired state sequence and the second acquired state sequence.

In an embodiment, the determination module 702 is configured to: determine, from the first acquired state sequence in the knowledge base using the second state sequence as a comparison target, a hit region meeting the comparison target; determine, from the second acquired state sequence, a latest state that is of the digital twin and that corresponds to a latest state of the virtual control system in the hit region; and determine the latest state of the digital twin as the desired state.

In an embodiment, the second state sequence has a predetermined time length; and the determination module 702 is configured to: slide a time window having the time length in the first acquired state sequence in the knowledge base; determine a region that is within the time window and that has a maximum similarity with the second state sequence; and determine the region having the maximum similarity as the hit region.

In summary, in the embodiments of the present invention, when a state of a digital twin is not synchronous with that of a physical system, the state of the digital twin can be automatically refreshed without participation of an engineer. In addition, a synchronization manner has a high tolerance: even in an expected case, a digital twin model can be automatically recovered after several rounds. In addition, no a priori knowledge is required to generate a knowledge base, and the knowledge base may be iteratively generated by executing the digital twin.

Embodiments of the present invention further provide an electronic device having a processor-memory architecture. FIG. 8 is a structural diagram of an electronic device according to an embodiment of the present invention. As shown in FIG. 8, an electronic device 800 includes a processor 801, a memory 802, and a computer program that is stored in the memory 802 and that can be run on the processor 801. The computer program, when executed by the processor 801, implements any foregoing state synchronization method for a digital twin. The memory 802 may be specifically implemented as various storage media such as an electrically-erasable programmable read-only memory (EEPROM), a flash memory, and a programmable read-only memory (PROM). The processor 801 may be implemented to include one or more central processing units or one or more field-programmable gate arrays. The field-programmable gate array integrates one or more central processing unit cores. Specifically, the central processing unit or the central processing unit core can be implemented as a CPU, an MCU, a DSP, or the like.

It should be noted that not all steps and modules in the flowcharts and structural diagrams are necessary, and some steps or modules may be omitted according to an actual requirement. An execution sequence of the steps is not fixed and may be adjusted as required. Division of the modules is merely functional division for ease of description. During actual implementation, one module may be separately implemented by multiple modules, and functions of multiple modules may also be implemented by one same module. These modules may be located in a same device, or may be located in different devices.

Hardware modules in the embodiments may be implemented in a mechanical manner or an electronic manner. For example, one hardware module may include a specially designed permanent circuit or logical device (for example, a dedicated processor, for example, an FPGA or an ASIC) for completing a specific operation. The hardware module may also include a programmable logic device or circuit (for example, including a general-purpose processor or another programmable processor) configured temporarily by software and configured to perform a specific operation. The hardware module is specifically implemented in a mechanical manner, using a dedicated permanent circuit, or using a temporarily configured circuit (for example, configured by software), which may be determined in consideration of costs and time.

The foregoing is merely preferred embodiments of the present invention but is not used to limit the scope of protection of the present invention. Any modification, equivalent replacement, improvement, or the like made within the spirit and principle of the present invention shall fall within the protection scope of the present invention.

Nouns and pronouns related to people in this patent application are not limited to specific genders.

## Claims

1. A state synchronization method for a digital twin, comprising:
obtaining (101) a first state sequence and a second state sequence, wherein the first state sequence represents a state of a virtual control system for a digital twin, and the second state sequence represents a state of a control system for a mapped object of the digital twin;
when the first state sequence is inconsistent with the second state sequence, determining (102) a desired state of the digital twin based on the second state sequence; and
updating (103) a state of the digital twin to the desired state.

2. The method according to claim 1, comprising:
when the first state sequence is inconsistent with the second state sequence, updating a current state of the virtual control system for the digital twin to a latest state in the second state sequence.

3. The method according to claim 1, comprising:
running a simulation process of controlling the digital twin via the virtual control system;
synchronously acquiring a plurality of states of the virtual control system and a plurality of states of the digital twin in the simulation process, wherein the plurality of states of the virtual control system form a first acquired state sequence, and the plurality of states of the digital twin form a second acquired state sequence; and
generating a knowledge base comprising an association relationship between the first acquired state sequence and the second acquired state sequence.

4. The method according to claim 3, wherein the determining (102) a desired state of the digital twin based on the second state sequence comprises:
determining, from the first acquired state sequence in the knowledge base using the second state sequence as a comparison target, a hit region meeting the comparison target;
determining, from the second acquired state sequence, a latest state that is of the digital twin and that corresponds to a latest state of the virtual control system in the hit region; and
determining the latest state of the digital twin as the desired state.

5. The method according to claim 4, wherein the second state sequence has a predetermined time length; and
the determining, from the first acquired state sequence in the knowledge base using the second state sequence as a comparison target, a hit region meeting the comparison target comprises:
sliding a time window having the time length in the first acquired state sequence in the knowledge base;
determining a region that is within the time window and that has a maximum similarity with the second state sequence; and
determining the region having the maximum similarity as the hit region.

6. The method according to claim 1, comprising:
obtaining a current state of the virtual control system;
when the current state is the same as a latest state in the first state sequence, updating a timestamp of the latest state to a timestamp of the current state; and
when the current state is different from the latest state in the first state sequence, adding the current state to the first state sequence.

7. The method according to claim 1, comprising:
obtaining a current state of the control system;
when the current state is the same as a latest state in the second state sequence, updating a timestamp of the latest state to a timestamp of the current state; and
when the current state is different from the latest state in the second state sequence, adding the current state to the second state sequence.

8. A state synchronization apparatus for a digital twin, comprising:
an obtaining module (701), configured to obtain a first state sequence and a second state sequence, wherein the first state sequence represents a state of a virtual control system for a digital twin, and the second state sequence represents a state of a control system for a mapped object of the digital twin;
a determination module (702), configured to: when the first state sequence is inconsistent with the second state sequence, determine a desired state of the digital twin based on the second state sequence; and
an update module (703), configured to update a state of the digital twin to the desired state.

9. The apparatus according to claim 8, wherein
the determination module (702) is configured to: when the first state sequence is inconsistent with the second state sequence, update a current state of the virtual control system for the digital twin to a latest state in the second state sequence.

10. The apparatus according to claim 8, wherein
the determination module (702) is configured to: run a simulation process of controlling the digital twin via the virtual control system; synchronously acquire a plurality of states of the virtual control system and a plurality of states of the digital twin in the simulation process, wherein the plurality of states of the virtual control system form a first acquired state sequence, and the plurality of states of the digital twin form a second acquired state sequence; and generate a knowledge base comprising an association relationship between the first acquired state sequence and the second acquired state sequence.

11. The apparatus according to claim 10, wherein
the determination module (702) is configured to: determine, from the first acquired state sequence in the knowledge base using the second state sequence as a comparison target, a hit region meeting the comparison target; determine, from the second acquired state sequence, a latest state that is of the digital twin and that corresponds to a latest state of the virtual control system in the hit region; and determine the latest state of the digital twin as the desired state.

12. The apparatus according to claim 11, wherein the second state sequence has a predetermined time length; and
the determination module (702) is configured to: slide a time window having the time length in the first acquired state sequence in the knowledge base; determine a region that is within the time window and that has a maximum similarity with the second state sequence; and determine the region having the maximum similarity as the hit region.

13. A state synchronization system for a digital twin, comprising:
a virtual control system (602), configured to control a digital twin (601);
a control system (604), configured to control a mapped object (605) of the digital twin (601); and
a state synchronization apparatus (603), configured to: obtain a first state sequence and a second state sequence, wherein the first state sequence represents a state of the virtual control system (602) for the digital twin (601), and the second state sequence represents a state of the control system (604) for the mapped object (605) of the digital twin (601); when the first state sequence is inconsistent with the second state sequence, determine a desired state of the digital twin (601) based on the second state sequence; and update a state of the digital twin (601) to the desired state.

14. The system according to claim 13, wherein
the state synchronization apparatus (603) is configured to: run a simulation process of controlling the digital twin (601) via the virtual control system (602); synchronously acquire a plurality of states of the virtual control system (602) and a plurality of states of the digital twin (601) in the simulation process, wherein the plurality of states of the virtual control system (602) form a first acquired state sequence, and the plurality of states of the digital twin (601) form a second acquired state sequence; and generate a knowledge base comprising an association relationship between the first acquired state sequence and the second acquired state sequence.

15. The system according to claim 13, wherein
the state synchronization apparatus (603) is configured to: determine, from a first acquired state sequence in the knowledge base using the second state sequence as a comparison target, a hit region meeting the comparison target; determine, from a second acquired state sequence, a latest state that is of the digital twin (601) and that corresponds to a latest state of the virtual control system (602) in the hit region; and determine the latest state of the digital twin (601) as the desired state.

16. The system according to claim 15, wherein the second state sequence has a predetermined time length; and
the state synchronization apparatus (603) is configured to: slide a time window having the time length in the first acquired state sequence in the knowledge base; determine a region that is within the time window and that has a maximum similarity with the second state sequence; and determine the region having the maximum similarity as the hit region.

17. An electronic device, comprising:
a processor (801); and
a memory (802), configured to store executable instructions of the processor (801), wherein
the processor (801) is configured to read the executable instructions from the memory (802) and execute the executable instructions to implement the state synchronization method for a digital twin according to any one of claims 1 to 7.

18. A computer-readable storage medium, having computer instructions stored therein, wherein the computer instructions, when executed by a processor, implement the state synchronization method for a digital twin according to any one of claims 1 to 7.

19. A computer program product, comprising a computer program, wherein the computer program, when executed by a processor, implements the state synchronization method for a digital twin according to any one of claims 1 to 7.
